# EUROPÄISCHE PATENTSCHRIFT

(11) **EP 1 275 995 B1**
(45) Veröffentlichungstag und Bekanntmachung des Hinweises auf die Patenterteilung: **08.03.2006**
(21) Anmeldenummer: 02014674.2
(22) Anmeldetag: 03.07.2002
(51) Int. Cl.: G02B 7/00, G03F 7/20

(54) **Belichtungsobjektiv mit mehreren optischen Elementen**
Exposure lens with a plurality of optical elements
Objectif d'exposition avec plusieurs éléments optiques

(30) Priorität: 14.07.2001 DE 10134387
(43) Veröffentlichungstag der Anmeldung: 15.01.2003
(73) Patentinhaber: Carl Zeiss SMT AG, 73447 Oberkochen (DE)
(72) Erfinder: Hof, Albrecht, Dr., 73430 Aalen (DE); Maul, Guenter, Dipl.-Ing., 73431 Aalen (DE); Muehlbeyer, Michael, Dipl.-Ing., 73430 Aalen (DE); Mehlkopp, Klaus c/o Transfemton GmbH, 52477 Alsdorf (DE)
(74) Vertreter: Lorenz, Werner

(56) Entgegenhaltungen:
- EP-A- 0 397 179
- DE-C- 4 134 016
- US-A- 5 633 681
- US-A- 6 036 162

## Beschreibung

Die Erfindung betrifft ein Belichtungsobjektiv für die Halbleiter-Lithographie mit mehreren optischen Elementen nach der im Oberbegriff von Anspruch 1 näher definierten Art. Außerdem betrifft die Erfindung ein Verfahren zum Verändern der Lage eines Objekts und/oder eines Bildes in einem derartigen Belichtungsobjektiv.

Bei optischen Systemen, welche zur Erzeugung von optischen Abbildungen mit einer sehr hohen Genauigkeit geeignet sein sollen, beispielsweise optische Systeme für sehr kurzwellige Strahlung, wie beispielsweise Strahlung im Bereich des extremen Ultraviolett (EUV), müssen die einzelnen optischen Elemente hinsichtlich ihrer Ausrichtung in allen sechs Freiheitsgraden möglichst exakt positioniert werden können.

Dafür weisen derartige optische Systeme häufig Sensoren oder dergleichen auf, welche die Lage der optischen Elemente, im oben beschriebenen Fall der EUV-Strahlung im allgemeinen Spiegel, entsprechend überwachen, sowie Manipulatoren, um die optischen Elemente in ihrer Lage nachzuregeln bzw. einzujustieren.

Beim Betrieb derartiger optischer Systeme, welche beispielsweise Belichtungsobjektive für die Halbleiter-Lithographie sein können, kommt es nun zu entsprechenden Belastungen des optischen Systems selbst, welche in diesem von einer lastabtragenden Struktur aufgenommen werden. Neben den durch die Gewichtskräfte der Einzelkomponenten gegebenen statischen Belastungen können dabei aufgrund von auftretenden Schwingungen oder Reaktionskräften auch dynamische Belastungen vorkommen. Durch die Integration der Sensoren in das Objektiv selbst werden diese Belastungen häufig jedoch nicht erfaßt, da auch die Lage der Sensoren, welche immer als Referenz für die Messung genutzt wird, von derartigen Belastungen abhängig ist.

In dem Fachartikel "Foundations of Ultraprecision Mechanism Design" von S.T. Smith und D.G. Chetwynd aus "Developments in Nanotechnology" der Universität von Warwick, UK, welcher über GORDON AND BREACH SCIENCE PUBLISHERS veröffentlicht worden ist, ist die grundlegende Trennung von kraftschlüssigen Kreisen und Meßkreisen, welche einerseits die Last abtragen und andererseits die Messung beinhalten, beschrieben.

Die in dem dortigen Artikel als Meßkreise (measurement loops) bezeichneten geschlossenen Wege sind dabei verantwortlich, die zu messenden Objekte und das Meßwerkzeug zueinander zu koordinieren.

Die US 6,036,162 betrifft eine Vibrationsdämpfung in einer Vorrichtung, insbesondere einer Projektionsbelichtungsanlage mit einem optischen Projektionssystem, wobei Vibrationsdämpfungseinheiten und Messsysteme zur Positionierung des gesamten optischen Projektionssystems vorgesehen sind.

Im Sinne dieser Überlegungen liegt die Aufgabe der vorliegenden Erfindung darin, ein Belichtungsobjektiv zu schaffen, welches es ermöglicht, eine hohe Genauigkeit der erforderlichen Messungen und damit ein exaktes Einregeln der jeweiligen Position der einzelnen optischen Elemente zu ermöglichen. Außerdem ist es Aufgabe der Erfindung, ein Verfahren zum Ändern der Lage eines Objektes und/oder eines Bildes in einem derartigen Belichtungsobjektiv zu schaffen.

Die oben genannte Aufgabe wird erfindungsgemäß durch Anspruch 1 gelöst.

Dadurch, daß das Belichtungsobjektiv zwei vollkommen voneinander getrennte Strukturen enthält, wobei eine Struktur als lastabtragende Struktur zur Aufnahme der optischen Elemente und zum Abführen der im Bereich der optischen Elemente entstehenden Gewichtskräfte und dynamischer Kraftkomponenten vorgesehen ist, während die andere Struktur als reine Meßstruktur bzw. als Meß- oder Referenzrahmen ausgebildet ist, wird die ideale Möglichkeit zur Überwachung der Positionen der einzelnen in der lastabtragenden Struktur aufgenommenen Elemente gegenüber einer sicheren und gleichbleibenden Referenz geschaffen. Die lastabtragende Struktur trägt dabei - wie oben bereits erwähnt wurde - die gesamte Last der optischen Elemente und übernimmt die bei einer Bewegung der optischen Elemente auftretenden Reaktionskräfte. Die Meßstruktur trägt dagegen nur ihr eigenes Gewicht sowie das Gewicht von eventuell auf ihr angebrachten Sensoren, so daß eine sehr hohe Stabilität und Genauigkeit der Meßstruktur zu erreichen ist.

Gemäß einer besonders günstigen Ausgestaltung der oben genannten Erfindung ist die Meßstruktur dabei außerdem in das Belichtungsobjektiv selbst integriert. So erhält man praktisch ein Belichtungsobjektiv, welches als in sich geschlossenes System in einer entsprechende Maschine oder dergleichen eingesetzt werden kann, insbesondere in einem entsprechenden Scanner, Stepper oder dergleichen.

Das Belichtungsobjektiv erlaubt in sich eine exakte und von den äußeren Umständen praktisch unabhängige Positionierung der einzelnen optischen Elemente, so daß eine gleichbleibend gute Abbildungsqualität, unabhängig von Umgebungsbedingungen, Alterungs- und Setzeffekten oder dergleichen, gegeben ist.

Eine Lösung für den verfahrensgemäßen Teil der oben genannten Aufgabe ist in Anspruch 19 angegeben.

Dadurch, daß die Lage des Objektes und/oder des Bildes durch ein Verändern der Position der optischen Elemente in dem Belichtungsobjektiv verändert werden kann, ergeben sich erhebliche Vereinfachungen hinsichtlich der Peripherie des Belichtungsobjektivs. Insbesondere beim oben bereits erwähnten Einsatz in einem Scanner für die Halbleiter-Lithographie, ergeben sich durch diese verfahrensgemäßen Möglichkeiten entscheidende Vorteile.

Beispielsweise kann die Lage des Reticles, also der die Ausgangsbasis für das auf den Wafer zu belichtende Muster bildenden Maske gegenüber der exakten Lage des Wafers durch ein Nachschieben der optischen Elemente korrigiert werden. Dazu muß lediglich die Lage des Reticles und des Wafers gegenüber der Meßstruktur bekannt bzw. meßbar sein. Dann läßt sich praktisch durch ein entsprechendes Anpassen der optischen Elemente das durch das Belichtungsobjektiv erzeugte Bild in seiner Position nachjustieren.

Durch einen derartigen erfindungsgemäßen Aufbau des Belichtungsobjektivs, welcher hinsichtlich der zu erzielenden Abbildungsqualität aufgrund der oben genannten Gründe entsprechende Vorteile hat, wäre es damit problemlos möglich, auch die Lage des Objektes und/oder des Bildes durch ein entsprechendes Verändern der Lage der optischen Elemente zu korrigieren. Aufwendige und aufgrund der Feinmechanik vergleichsweise teure Einrichtungen zur mechanischen Positionierung von Reticle und/oder Wafer könnten damit entfallen oder zumindest vereinfacht werden, da die entsprechenden Korrekturen durch ein Verschieben der jeweiligen optischen Elemente gegenüber der Meßstruktur einfach möglich wird.

Weitere vorteilhafte Ausgestaltungen der Erfindung ergeben sich aus den restlichen Unteransprüchen sowie aus den anhand der Zeichnung nachfolgend dargestellten Ausführungsbeispielen.

Es zeigt:
- Figur 1: eine prinzipmäßige Darstellung eines erfindungsgemäßen optischen Systems;
- Figur 2 a: eine mögliche Anordnung von Abstandssensoren auf einer Würfelecke;

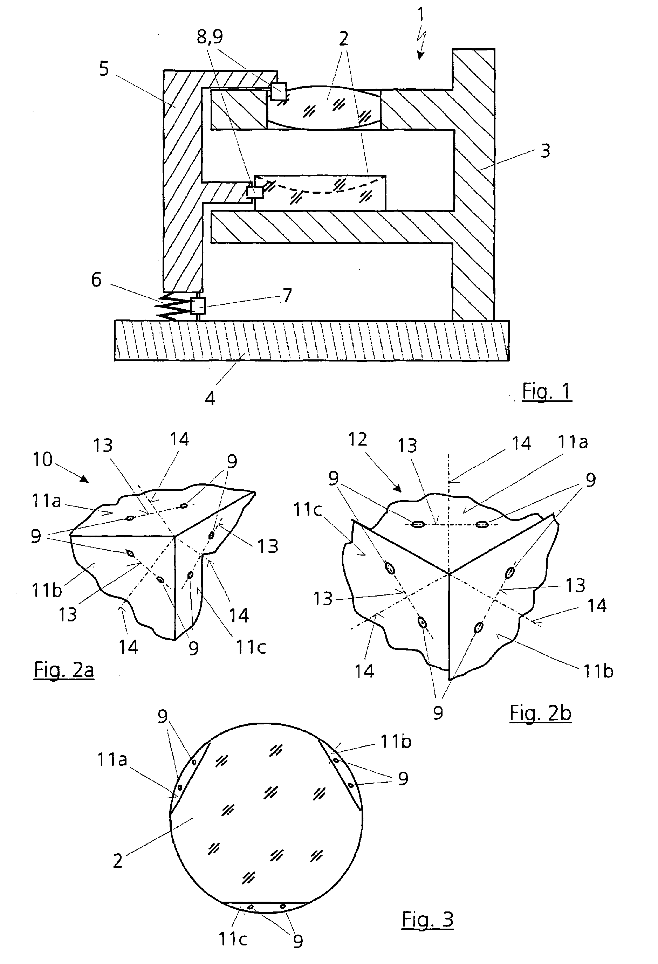

- Figur 2 b: eine mögliche Anordnung von Abstandssensoren in einer Raumecke;

- Figur 3: eine Anordnung von drei für die Messung erforderlichen Ebenen an einem optischen Element;

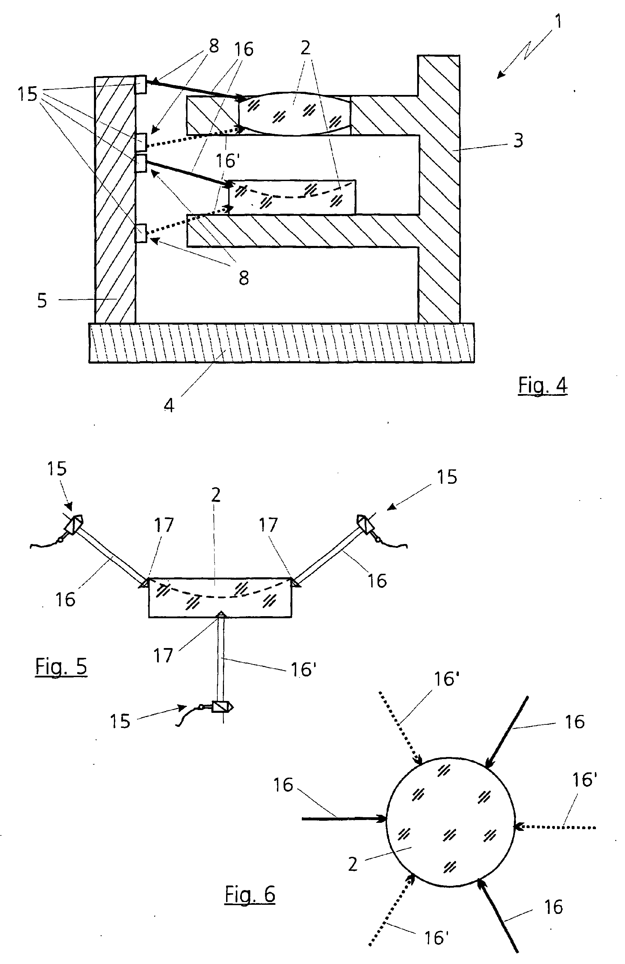

- Figur 4: eine prinzipmäßige Darstellung eines erfindungsgemäßen optischen Systems in einer alternativen Ausführungsform;
- Figur 5: eine Prinzipdarstellung eines möglichen Aufbaus, bei welchem interferometrische Meßstrecken eingesetzt werden; und
- Figur 6: der Aufbau gemäß Figur 5 in einer prinzipmäßigen Draufsicht.

Figur 1 zeigt eine prinzipmäßige Darstellung eines optischen Systems 1, welches mehrere optische Elemente 2 aufweist. In dem hier dargestellten, sehr stark schematisierten Ausführungsbeispiel sind als optische Elemente 2 eine Linse und ein Spiegel angedeutet. Grundlegend ist jedoch die Verwendung sämtlicher bekannter optischer Elemente denkbar, wobei für den bevorzugten Einsatzzweck des optischen Systems 1 als Belichtungsobjektiv in der Halbleiter-Lithographie, insbesondere im extremen Ultraviolett (EUV), reflektierende optische Elemente 2, also Spiegel, Verwendung finden sollen.

Die optischen Elemente 2 sind auf einer lastabtragenden Struktur 3 des optischen Systems 1 angeordnet, welche hier ebenfalls nur stark schematisiert dargestellt ist. Die lastabtragende Struktur 3 nimmt sowohl die statischen, durch die Gewichtskräfte der optischen Elemente 2 und der Struktur 3 selbst entstehenden Kräfte sowie eventuell auftretende dynamische Kräfte auf, die aufgrund von Schwingungen, welche das optische System 1 als ganzes erfährt, in diesem auftreten können.

Die optischen Elemente 2 sind mit an sich bekannter Fassungstechnik in der lastabtragenden Struktur 3 aufgehängt. Sie sind entweder fest montiert oder können im Rahmen ihrer Fassungen über entsprechende, hier nicht dargestellte,'aber gemäß dem Stand der Technik an sich bekannte Manipulatoren in z.B. drei, insbesondere jedoch in allen sechs Freiheitsgraden manipuliert werden.
Die lastabtragende Struktur 3 selbst ist auf einer Grundplatte 4 des optischen Systems 1 angebracht, insbesondere fest mit dieser verbunden.

Des weiteren weist das optische System 1 eine Meßstruktur 5 auf, welche als eigenständiger mechanischer Referenzrahmen dient und welche vollkommen unabhängig von der lastabtragenden Struktur 3 aufgebaut ist. In dem in Figur 1 prinzipmäßig angedeuteten Ausführungsbeispiel ist die Meßstruktur 5 über eine Kombination eines Federmittels 6 und eines Dämpfer 7 auf der Grundplatte 4 des optischen Systems 1 aufgebaut. Durch den entsprechenden Dämpfer 7 und ein möglichst weiches Federmittel läßt sich somit eine fast vollständige Entkopplung zwischen der in das optische System 1 integrierten Meßstruktur 5 und der Grundplatte 4 erreichen.

Um eine möglichst steife und von Umgebungseinflüssen unabhängige Meßstruktur 5 als Referenzrahmen für das optische System 1 zu erhalten, sollte die Meßstruktur 5 selbst möglichst leicht und dennoch stabil, beispielsweise aus tetraederförmigen Verstrebungen oder dergleichen, aufgebaut sein. Als Materialien sind dabei insbesondere Materialien geeignet, welche aufgrund ihres mikroskopischen Aufbaus einen makroskopisch wenigstens annähernd verschwindenden Wärmeausdehnungskoeffizienten aufweisen, so daß Temperatureinflüsse die Meßstruktur 5 nicht beeinflussen. Derartige Materialien können beispielsweise Invar ZERODUR oder ULE sein, wobei sich ZERODUR und/oder ULE als besonders geeignet herausgestellt haben.

Die Entkopplung aus dem Federmittel 6 und dem Dämpfer 7 sorgt in dem in dem Ausführungsbeispiel gemäß Figur 1 dargestellten Fall neben der Entkopplung hinsichtlich Kräften und Schwingungen ebenfalls für eine Entkopplung zwischen dem von thermischen Schwankungen unbeeinflußten Aufbau der Meßstruktur 5 und dem sich aufgrund thermischer Längenausdehnung verändernden Aufbau der Grundplatte 4 und der lastabtragenden Struktur 3.

Wie in Figur 1 prinzipmäßig dargestellt, weist die Meßstruktur 5 angedeutete Einrichtungen 8 zur Erfassung der exakten Position der optischen Elemente 2 gegenüber der Meßstruktur 5 als Referenzrahmen auf. Die Einrichtungen 8 sind entgegen der prinzipmäßigen Darstellung in Figur 1 so ausgebildet, daß es im Bereich dieser Einrichtungen 8 zu keinem direkten Kontakt zwischen der Meßstruktur 3 und dem jeweiligen optischen Element 2 bzw. dessen lastabtragender Struktur 3 kommt. Beispielsweise können die Einrichtungen 8 zum Erfassen der Lage des optischen Elements 2 als berührungslose Sensoren 9 ausgebildet sein. Geeignete Sensortypen wären dabei sicherlich kapazitive Abstandssensoren oder gegebenenfalls auch induktive Sensoren.

Figur 2a zeigt nun eine Möglichkeit, derartige Sensoren 9, im vorliegenden Fall soll es sich um kapazitive Abstandssensoren 9 handeln, anzuordnen. Figur 2a zeigt eine in einer dreidimensionalen Darstellung angeordnete Würfelecke 10, welche aus drei Ebenen 11a, 11b, 11c gebildet wird, welche sich in einem Winkel von jeweils 90° zueinander schneiden. Eine derartige Würfelecke 10 kann beispielsweise fest mit dem jeweiligen optischen Element 2 verbunden sein und korrespondiert dann mit einer fest mit der Meßstruktur 5 verbundenen Raumecke 12, wie sie in Figur 2b dargestellt ist. Auch die Raumecke 12 besteht aus drei Ebenen 11a, 11b, 11c, welche sich in einem Winkel von jeweils 90° zueinander in einem Punkt schneiden.

Um nun über eine derartige Würfelecke 10 mit einer korrespondierenden Raumecke 12 Positionsänderungen des optischen Elements 2 in allen sechs Freiheitsgraden erfassen zu können, sind in jeder der Ebenen 11a, 11b, 11c jeweils zwei Sensoren 9 angeordnet. Grundsätzlich wäre es auch denkbar, in einer der Ebenen 11a drei Sensoren 9 anzuordnen, in der nächsten Ebene 11b zwei und in der letzten Ebene 11c jeweils einen Sensor 9. Der in den Figuren 2a und 2b dargestellte Aufbau hat jedoch den Vorteil, daß mit einfachen und mechanisch sehr leicht zu realisierenden Mitteln eine sehr exakte Messung erzielt werden kann, wobei diese Messung bei einem Einsatz von derartigen kapazitiv ausgebildeten Sensoren 9 jeweils eine Absolutmessung darstellt. Das jeweilige Paar der Sensoren 9 in der jeweiligen Ebene 11a, 11b, 11c ist dabei so angeordnet, daß eine gedachte Verbindungslinie 13 zwischen den beiden Sensoren 9 in einem Winkel von ca. 60° bis 120°, vorzugsweise in einem rechten Winkel, auf einer Winkelhalbierenden 14 steht. Die Winkelhalbierende 14 geht dabei von dem Schnittpunkt der drei Ebenen 11a, 11b, 11c aus und verläuft als Winkelhalbierende 14 zwischen den Schnittlinien, welche die jeweilige Ebene 11a, 11b, 11c, in welcher die Winkelhalbierende 14 liegt, mit den beiden benachbarten Ebenen bildet. Mit diesem Aufbau der Sensoren 9 sowohl in der Würfelecke 10 als auch in der korrespondierenden Raumecke 12 läßt sich die Position des jeweiligen optischen Elements 2 in allen sechs Freiheitsgraden absolut erfassen.

Um eine ideale Funktionsweise des optischen Systems 1 zu erreichen, sollte dabei jedes der optischen Elemente 2 derartige Einrichtungen 8 zur Bestimmung seiner Position bzw. Lage aufweisen.

Neben der oben bereits erwähnten Möglichkeit, das optische Element 2 mit der Würfelecke 10 oder gegebenenfalls auch der Raumecke 12 fest zu verbinden und das entsprechende Gegenstück, also die Raumecke 12 oder die Würfelecke 10, im Bereich der Meßstruktur 5 zu realisieren, besteht auch die Möglichkeit, daß das optische Element 2 die drei senkrecht aufeinander stehenden Ebenen 11a, 11b, 11c selbst enthält.

In Figur 3 ist ein derartiger Aufbau dargestellt, bei dem im Randbereich des optischen Elements 2 die jeweiligen Ebenen 11a, 11b, 11c angebracht sind, welche die entsprechenden Sensoren 9 tragen. Auch hier sind die korrespondierenden Ebenen 11a, 11b, 11c mit den jeweiligen Gegenstücken der Sensoren 9 auf der Meßstruktur 5 angeordnet, so daß die Messung absolut gegenüber der Meßstruktur 5 erfolgt.

Selbstverständlich müssen die Ebenen 11a, 11b, 11c dabei nicht als solche existent sein. Es reicht aus, wenn die Sensoren 9 in der jeweiligen virtuellen Ebene 11a, 11b, 11c angeordnet sind.
Figur 4 zeigt nun einen alternativen Aufbau des optischen Systems 1, bei dem als erster Unterschied die Verbindung zwischen der Meßstruktur 5 und der Grundplatte 4 als direkte mechanische Verbindung ausgebildet ist. Je nach äußeren Gegebenheiten kann dies gegebenenfalls möglich sein, sofern für die Grundplatte 4 keine allzu großen Einflüsse durch die lastabtragende Struktur 3 zu erwarten sind. Je nach verwendetem Material für die Meßstruktur 5 kann auch hier eine Entkopplung von thermischen Ausdehnungen sinnvoll sein, welche beispielsweise über entsprechende Materialien realisiert sein kann, welche durch ihren mikroskopischen Aufbau so ausgebildet sind, daß sie makroskopisch einen Übergang von einem bestimmten Wärmeausdehnungskoeffzienten an ihrem einen Ende zu einem anderen Wärmeausdehnungskoeffizienten an ihrem anderen Ende beinhalten.

Die Einrichtungen 8 zum Erfassen der Lage der optischen Elemente 2 sind in dem hier dargestellten Ausführungsbeispiel als von Laserinterferometern 15 gebildete interferometrische Meßstrecken 16, 16' realisiert. Auf die Unterschiede zwischen den mit durchgehenden Pfeilen angedeuteten interferometrischen Meßstrecken 16 und den mit gepunkteten Pfeilen angedeuteten interferometrischen Meßstrecken 16' wird im weiteren Verlauf des Ausführungsbeispiels noch näher eingegangen.

Bei der oben beschriebenen Absolutmessung der Lage der einzelnen optischen Elemente 2 mit den kapazitiven Sensoren 9 muß die Meßstruktur 5 sehr dicht an die zu messenden optischen Elemente heranragen. Dadurch können gegebenenfalls Konflikte mit der lastabtragenden Struktur 3 bei der Konstruktion eines derartigen optischen Systems 1 entstehen. Die interferometrischen Meßstrecken 16, 16' weisen dieses Problem nicht auf, da ihr Ausgangspunkt im Bereich der Meßstruktur 5 gegebenenfalls auch einen vergleichsweise großen Abstand zu dem hinsichtlich seiner Lage zu vermessenden optischen Element 2 aufweisen können. Um mit den Laserinterferometern 15 entsprechend arbeiten zu können, müssen dafür lediglich entsprechende Wege für die Strahlen freigehalten werden, welche üblicherweise einen Durchmesser von jeweils wenigen Millimetern aufweisen. Derartige, beispielsweise mittels Bohrungen von 5 mm Durchmesser realisierte Strahlwege sind beim konstruktiven Aufbau der lastabtragenden Struktur 3 sehr leicht zu realisieren und beeinflussen deren Festigkeit kaum.

Aufgrund der sehr kleinen auftretenden Bewegungen können außerdem Interferometer 15 mit Tripelspiegeln benutzt werden, deren Kennlinien dann in einer über eine elektronische Datenverarbeitung, welche hier nicht explizit dargestellt ist, erfolgenden Positionsberechnungen der einzelnen optischen Elemente 2 in allen Freiheitsgraden berücksichtigt werden können.

Wie bereits oben erwähnt, soll dabei jedes der optischen Elemente 2 nach Möglichkeit in sechs Freiheitsgraden hinsichtlich seiner aktuellen Lage vermeßbar sein. Analog zu den sechs oben eingesetzten kapazitiven Sensoren 9 können dementsprechend sechs Laserinterferometer 15 je zu vermessenden optischem Element 2 eingesetzt werden.

Figur 5 zeigt eine prinzipmäßige Darstellung dieses Aufbaus, wobei hier lediglich drei der Laserinterferometer 15 dargestellt sind. Die von den Laserinterferometern 15 ausgehenden Strahlen der jeweiligen Meßstrecke 16, 16' werden dabei von Retroreflektoren 17 reflektiert, welche im Bereich des optischen Elements 2 angeordnet sind. Besonders günstig ist es auch hier wieder, wenn diese Retroreflektoren 17 derart an dem optischen Element angeordnet sind, wie dies für die Ausgestaltung der Ebenen 11a, 11b, 11c und dem Ausführungsbeispiel gemäß Figur 3 beschrieben wurde. Es wäre also denkbar, daß die Retroreflektoren 17 an dem optischen Element selbst in dessen Randbereich angebracht sein könnten.

Um die Lage des jeweiligen optischen Elements 2 nun in allen sechs Freiheitsgraden vermessen zu können, sind wie oben bereits erwähnt, sechs Laserinterferometer 15 notwendig. Die Laserinterferometer 15 sollten so angeordnet sein, daß drei der Laserinterferometer das optische Element 2 von schräg oben vermessen, wie dies in Figur 4 durch die Meßstrecken 16 angedeutet ist. Die drei verbleibenden Laserinterferometer 15 sollten das optische Element im Gegensatz zu den eben Beschriebenen von schräg unten vermessen, wie dies durch die Meßstrecken 16' in Figur 4 angedeutet ist.

Um ein ideales Ergebnis zu erzielen, sollten die einzelnen Meßstrecken 16, 16' dabei jeweils in den entsprechenden Winkeln zueinander angeordnet sein. In Figur 6 ist dieser Aufbau in einer Draufsicht erkennbar, wobei hier die drei von oben kommenden Meßstrecken 16 in einem Winkel von jeweils 120° zueinander angeordnet sind. Die drei von unten kommenden Meßstrecken 16' sind ebenfalls in einem Winkel von 120° zueinander und in einem Winkel von jeweils 60° zu den Meßstrecken 16 angeordnet. Mit diesem Aufbau läßt sich die Position des optischen Elements 2 in allen sechs Freiheitsgraden erfassen und aufgrund der Teilung der den entsprechenden Kräften ausgesetzten lastabtragenden Struktur 3 von der die Referenz verkörpernden Meßstruktur 5 exakt und unabhängig von den Einflüssen dynamischer und statischer Kräfte in dem optischen System 1 vermessen. Da die Laserinterferometer 15 nur inkrementell messen, muß über die oben bereits erwähnte und nicht dargestellte elektronische Datenverarbeitung beim Start des jeweiligen Systems ein sinnvoller Startwert für die Position geladen werden. Beispielsweise wird dazu ein Referenzpunkt angefahren und dessen exakte Position gegenüber der Meßstruktur 5 dann als Null definiert.

Wenn die optischen Elemente in einer Ruhelage innerhalb derselben Zählperioden der Laserinterferometer 15 liegen, beispielsweise bei 632/2 nm, dann muß dieser Offset nur einmal ausgemessen bzw. bestimmt werden. Mit diesem Wert lassen sich sämtliche weitere Positionsbestimmungen bzw. Positionsberechnungen realisieren. Eine erneute Referenzierung muß erst dann wieder durchgeführt werden, wenn der Referenzpunkt aus der Zählperiode herausgewandert ist. Da dieser Fall in der Praxis kaum auftreten wird, ist dies jedoch von untergeordneter Bedeutung. Die notwendigen Referenzierungen sind also in der Praxis auf das jeweilige Einschalten des optischen Systems 1 beschränkt.

Grundlegend wäre es bei beiden Aufbauten, also sowohl bei der Verwendung der Laserinterferometer 15 als auch der Sensoren 9 möglich, die Messung überbestimmt durchzuführen. Dies würde bedeuten, daß anstatt der sechs unbedingt notwendigen Sensoren 9 bzw. Meßstrecken 16, 16' mindestens sieben Sensoren 9 bzw. Meßstrecken 16, 16' benutzt werden. Über die in der elektronischen Datenverarbeitung erfolgende Positionsberechnung läßt sich so die Messung sicherer gestalten. Außerdem würde ein derartiger Aufbau mit wenigstens sieben Einrichtungen 8 zur Bestimmung der Lage von jeweils einem der optischen Elemente 2 dazu führen, daß bei der Verwendung von interferometrischen Meßstrecken 16, 16' das oben genannte Problem des Erzeugens von Startwerten oder des Anfahrens eines Referenzpunkts nicht weiter auftreten würde, da durch die überbestimmte Messung auch hier eine entsprechende Berechnung von absoluten Positionswerten möglich wäre.

Neben den sehr günstigen Einflüssen eines gemäß den oben beschriebenen Ausführungsbeispielen aufgebauten optischen Systems 1 auf die Abbildungsqualität läßt sich mit dem optischen System 1 außerdem ein Verfahren realisieren, bei welchem die Lage eines Objekts und/oder eines Bildes im optische System 1 verändert werden kann.

Grundlegend wäre es denkbar, daß die in an sich bekannter Weise manipulierbar im Bereich der lastabtragenden Struktur 3 gelagerten optischen Elemente 2 allesamt aufgrund der als Referenzrahmen dienenden Meßstruktur 5 exakt in eine Richtung verschoben werden könnten. Wird das optische System 1 beispielsweise als Belichtungsobjektiv in der Halbleiter-Lithographie eingesetzt, ließe sich somit eine Fehlstellung des Reticles und/oder des Wafers in der Ebene senkrecht zur optischen Achse korrigieren. Dazu werden sämtliche optischen Elemente 2 um einen die Fehlstellung kompensierender Betrag in der jeweiligen Ebene zur optischen Achse nachreguliert. Bei feststehendem optischen System 1 können also alle optischen Elemente 2 in eine Richtung verschoben werden, so daß dies praktisch dem Nachjustieren des gesamten optischen Systems 1 hinsichtlich der Lage des Reticles entspricht. Dies wird insbesondere dadurch möglich, daß die dabei auftretenden dynamischen Belastungen die Messung der neuen Position nicht verfälschen können, da diese jeweils gegenüber der als Referenzrahmen dienenden Meßstruktur 5 gemessen wird, welche von diesen Vorgängen aufgrund der thermischen und mechanischen Entkopplung vom Rest des optischen Systems 1 unbeeinflußt bleibt. Vergleichbares wäre auch denkbar bei einer Verkippung des Reticles und/oder Wafers um die optische Achse, wobei hier jedoch im Bereich des optischen Systems 1 Fehler und Ungenauigkeiten auftreten könnten, welche je nach Anforderungen gegebenenfalls nur schwer zu tolerieren wären.

Auf jeden Fall wäre es aber mit einem derartigen Aufbau, welcher die sehr günstigen Eigenschaften bei der Abbildung ermöglicht, denkbar, eine sehr aufwendige Feinpositionierung sowohl des Wafers als auch des Reticles in einer Maschine zur Belichtung von Halbleiter-Bauelementen einzusparen, da sämtliche optischen Elemente 2 aufgrund der exakten Meßbarkeit ihrer Lage über der Meßstruktur 5 entsprechend nachjustiert werden können, um Fehler in der Feinpositionierung des Reticles bzw. des Wafers auszugleichen. Aufwendige und aufgrund der zu erzielenden Genauigkeit beim augenblicklichen Stand der Technik sehr teure Feinpositionierungseinrichtungen für Wafer und Reticle können damit eingespart werden. Das optische System 1 sollte als ideal arbeitendes optisches System 1 ohnehin die oben beschriebenen Aufbauten beinhalten, so daß die Veränderung der Lage des Objekts und/oder Bildes mit minimalem zusätzlichem Regelungsaufwand und ohne zusätzliche Bauelemente zu realisieren ist.

## Patentansprüche

1. Belichtungsobjektiv für die Halbleiter Lithographie mit mehreren optischen Elementen, welches wenigstens eine lastabtragende Struktur aufweist, die die von den optischen Elementen ausgehenden Kräfte ableitet, welches eine unabhängig von der wenigstens einen lastabtragenden Struktur (3) ausgebildete Meßstruktur (5) aufweist, **dadurch gekennzeichnet, daß** die Meßstruktur zur Überwachung der Position wenigstens eines einzelnen optischen Elements in dem Belichtungsobjektiv (1) vorgesehen ist.

2. Belichtungsobjektiv nach Anspruch 1, **dadurch gekennzeichnet, daß** die Meßstruktur (5) in das Belichtungsobjektiv (1) integriert ist.

3. Belichtungsobjektiv nach Anspruch 1 oder 2, **dadurch gekennzeichnet, daß** die Meßstruktur (5) Einrichtungen (8) aufweist, über welche die Lage von zumindest einer Anzahl der optischen Elemente (2) gegenüber der Meßstruktur (5) meßbar sind.

4. Belichtungsobjektiv nach Anspruch 3, **dadurch gekennzeichnet, daß** die Einrichtungen (8) zum Erfassen der Lage als Sensoren (9) ausgebildet sind, welche einen Abstand des jeweils korrespondierenden Gegenelements zu der Meßstruktur (5) absolut erfassen, wobei für jedes der optischen Elemente (2) wenigstens drei Sensoren (9) vorhanden sind.

5. Belichtungsobjektiv nach Anspruch 4, **dadurch gekennzeichnet, daß** die Sensoren (9) als kapazitive Sensoren ausgebildet sind.

6. Belichtungsobjektiv nach Anspruch 5, **dadurch gekennzeichnet, daß** wenigstens sechs Sensoren (9) je optisches Element (2) vorgesehen sind, welche in drei senkrecht zueinander stehenden Ebenen (11a,11b,11c) angeordnet sind.

7. Belichtungsobjektiv nach Anspruch 6, **dadurch gekennzeichnet, daß** die Sensoren (9) jeder Ebene (11a,11b,11c) paarweise angeordnet sind, wobei eine gedachte Verbindungslinie (13) zwischen den sensoren (9) jeweils einem Winkel von 60° bis 120°, vorzugsweise 90°, zu der von dem Schnittpunkt der drei Ebenen (11a,11b,11c) ausgehenden Winkelhalbierenden (14) zwischen den Schnittlinien der jeweiligen Ebene (11a) mit den benachbarten Ebenen (11b,11c) in der jeweiligen Ebene (11a) mit den Sensoren (9) liegt.

8. Belichtungsobjektiv nach Anspruch 6 oder 7, **dadurch gekennzeichnet, daß** mit jeder der Ebenen (11a,11b,11c), welche dem Bereich der Meßstruktur (5) zugeordnet ist, eine Ebene (11a,11b,11c) im Bereich des jeweiligen optischen Elements (2) korrespondiert.

9. Belichtungsobjektiv nach Anspruch 8, **dadurch gekennzeichnet, daß** die Ebenen (11a,11b,11c) im Bereich des optischen Elements (2) als Würfelecke (10) fest mit dem optischen Element (2) verbunden sind.

10. Belichtungsobjektiv nach Anspruch 8, **dadurch gekennzeichnet, daß** die Ebenen (11a,11b,11c) im Bereich des optischen Elements (2) als Referenzflächen an dem optischen Element (2) selbst ausgebildet sind.

11. Belichtungsobjektiv nach Anspruch 3 oder 4, **dadurch gekennzeichnet, daß** die Einrichtungen (8) zum Erfassen der Lage des optischen Elements (2) als interferometrische Meßstrecken (16,16') ausgebildet sind.

12. Belichtungsobjektiv nach Anspruch 11, **dadurch gekennzeichnet, daß** die Meßstrecken (16,16') über Laserinterferometer (15) aufgebaut sind, wobei jedem der optischen Elemente (2) wenigstens sechs Laserinterferometer (15) zugeordnet sind, welche ihrerseits ortsfest mit der Meßstruktur (5) verbunden sind.

13. Belichtungsobjektiv nach Anspruch 12, **dadurch gekennzeichnet, daß** die Laserstrahlen der Laserinterferometer (15) von fest mit dem optischen Element (2) verbundenen Retroreflektoren (17) reflektiert werden, wobei jedes optische Element (2) wenigstens sechs Retroreflektoren (17) aufweist, und wobei jeder der Retroreflektoren (17) mit einem der Laserinterferometer (15) korrespondiert.

14. Belichtungsobjektiv nach einem der Ansprüche 3 bis 13, **dadurch gekennzeichnet, daß** für jedes optische Element (2) wenigstens sieben Einrichtungen (8) zum Erfassen der Lage desselben vorgesehen sind.

15. Belichtungsobjektiv nach einem der Ansprüche 3 bis 14, **dadurch gekennzeichnet, daß** aus allen von den Einrichtungen (8) zum Erfassen der Lage des optischen Elements (2) ermittelten Werten in einer elektronischen Datenverarbeitungseinheit absolute Positionswerte der jeweiligen optischen Elemente (2) berechenbar sind.

16. Belichtungsobjektiv nach einem der Ansprüche 1 bis 15, **dadurch gekennzeichnet, daß** die lastabtragende Struktur (3) und die Meßstruktur (5) auf einer gemeinsamen Grundplatte (4) angeordnet sind.

17. Belichtungsobjektiv nach einem der Ansprüche 1 bis 16, **dadurch gekennzeichnet, daß** die Verbindung zwischen Meßstruktur (5) und lastabtragender Struktur (3) über eine Kombination aus wenigstens einem Federmittel (6) und wenigstens einem Dämpfer (7) ausgebildet ist.

18. Belichtungsobjektiv nach einem der Ansprüche 1 bis 17, **dadurch gekennzeichnet, daß** die Meßstruktur (3) aus einem Material ausgebildet ist, welches zumindest makroskopisch einen Wärmeausdehnungskoeffizienten aufweist, der wenigstens annähernd Null ist.

19. Verfahren zum Verändern der Lage eines Objekts und/oder eines Bildes in einem Belichtungsobjektiv nach einem der Ansprüche 1 bis 18, **dadurch gekennzeichnet, daß** die Lage des Objektes und/oder des Bildes durch ein Verändern der Position wenigstens eines einzelnen optischen Elements (2) in dem Belichtungsobjektiv (1) verändert wird, wobei die Position des optischen Elements (2) im Verhältnis zu der Meßstruktur (5) bei zumindest bekannter Lage des Objekts und Ziellage des Bildes im Verhältnis zu der Meßstruktur (5) gemessen wird.

## Claims

1. Exposure objective for semiconductor lithography having a plurality of optical elements, which comprises at least one load-relieving structure that dissipates the forces emerging from the optical elements, and which comprises a measurement structure (5) designed independently of the at least one load-relieving structure (3), **characterised in that** the measurement structure is intended for monitoring the position of at least one individual optical element in the exposure objective (1).

2. Exposure objective according to Claim 1, **characterised in that** the measurement structure (5) is integrated in the exposure objective (1).

3. Exposure objective according to Claim 1 or 2, **characterised in that** the measurement structure (5) comprises devices (8) via which the position of at least a number of the optical elements (2) can be measured relative to the measurement structure (5).

4. Exposure objective according to Claim 3, **characterised in that** the devices (8) for recording the position are designed as sensors (9) which absolutely record a distance of the respectively corresponding counter-element from the measurement structure (5), there being at least three sensors (9) for each of the optical elements (2).

5. Exposure objective according to Claim 4, **characterised in that** the sensors (9) are designed as capacitive sensors.

6. Exposure objective according to Claim 5, **characterised in that** at least six sensors (9) are provided per optical element (2), and these are arranged in three mutually perpendicular planes (11a, 11b, 11c).

7. Exposure objective according to Claim 6, **characterised in that** the sensors (9) of each plane (11a, 11b, 11c) are arranged pairwise, an imaginary connecting line (13) between the sensors (9) lying respectively at an angle of from 60° to 120°, preferably 90°, with respect to the angle bisectors (14) emerging from the intersection point of the three planes (11a, 11b, 11c) between the intersection lines of the respective plane (11a) with the neighbouring planes (11b, 11c) in the respective plane (11a) with the sensors (9).

8. Exposure objective according to Claim 6 or 7, **characterised in that** a plane (11a, 11b, 11c) in the region of the respective optical element (2) corresponds with each of the planes (11a, 11b, 11c) which is assigned to the region of the measurement structure (5).

9. Exposure objective according to Claim 8, **characterised in that** the planes (11a, 11b, 11c) are firmly connected to the optical element (2) as a corner-cube (10) in the region of the optical element (2).

10. Exposure objective according to Claim 8, **characterised in that** the planes (11a, 11b, 11c) are formed in the region of the optical element (2) as reference surfaces on the optical element (2) itself.

11. Exposure objective according to Claim 3 or 4, **characterised in that** the devices (8) for recording the position of the optical element (2) are designed as interferometric measurement branches (16, 16').

12. Exposure objective according to Claim 11, **characterised in that** the measurement branches (16, 16') are constructed usina laser interferometers (15), each of the optical elements (2) being assigned at least six laser interferometers (15) which are in turn connected positionally fixed to the measurement structure (5).

13. Exposure objective according to Claim 12, **characterised in that** the laser beams of the laser interferometers (15) are reflected by retroreflectors (17) firmly connected to the optical element (2), each optical element (2) comprising at least six retroreflectors (17) and each of the retroreflectors (17) corresponding with at least one of the laser interferometers (15).

14. Exposure objective according to one of Claims 3 to 13, **characterised in that** each optical element (2) is provided with at least seven devices (8) for recording its position.

15. Exposure objective according to one of Claims 3 to 14, **characterised in that** absolute position values of the respective optical elements (2) can be calculated in an electronic data-processing unit from all the values determined by the devices (8) for recording the position of the optical element (2).

16. Exposure objective according to one of Claims 1 to 15, **characterised in that** the load-relieving structure (3) and the measurement structure (5) are arranged on a common base plate (4).

17. Exposure objective according to one of Claims 1 to 16, **characterised in that** the connection between the measurement structure (5) and the load-relieving structure (3) is formed by a combination of at least one resilient means (6) and at least one damper (7).

18. Exposure objective according to one of Claims 1 to 17, **characterised in that** the measurement structure (3) is formed from a material which at least microscopically has a coefficient of thermal expansion of at least approximately zero.

19. A method for modifying the position of an object and/or an image in an exposure objective according to one of Claims 1 to 18, **characterised in that** the position of the object and/or image is modified by modifying the position of at least one individual optical element (2) in the exposure objective (1), the position of the optical element (2) being measured in relation to the measurement structure (5) at least with a known position of the object and target position of the image in relation to the measurement structure (5).

## Revendications

1. Objectif d'exposition pour la lithographie des semi-conducteurs avec plusieurs éléments optiques qui comprend au moins une structure porteuse qui dérive les forces provenant des éléments optiques et qui comprend une structure de mesure (5) conçue indépendamment de la structure porteuse (3), **caractérisé en ce que** la structure de mesure (5) est prévue pour la surveillance de la position d'au moins un élément optique dans l'objectif d'exposition (1).

2. Objectif d'exposition selon la revendication 1, **caractérisé en ce que** la structure de mesure (5) est intégrée dans l'objectif d'exposition (1).

3. Objectif d'exposition selon la revendication 1 ou 2, **caractérisé en ce que** la structure de mesure (5) comprend des dispositifs (8) grâce auxquels la position d'au moins certains éléments optiques (2) par rapport à la structure de mesure (5) peut être mesurée.

4. Objectif d'exposition selon la revendication 3, **caractérisé en ce que** les dispositifs (8) pour la mesure de la position sont conçus comme des capteurs (9) qui déterminent de manière absolue une distance entre l'élément correspondant et la structure de mesure (5), au moins trois capteurs (9) étant prévus chacun des éléments optiques (2).

5. Objectif d'exposition selon la revendication 4, **caractérisé en ce que** les capteurs (9) sont conçus comme des capteurs capacitifs.

6. Objectif d'exposition selon la revendication 5, **caractérisé en ce que** sont prévus au moins six capteurs (9) par élément optique (2), lesquels sont disposés sur trois plans (11a, 11b, 11c) perpendiculaires les uns par rapport aux autres.

7. Objectif d'exposition selon la revendication 6, **caractérisé en ce que** les capteurs (9) de chaque plan (11a, 11b, 11c) sont disposés par paires, une ligne de liaison imaginaire (13) se trouvant entre les capteurs (9) avec un angle de 60° à 120°, de préférence 90°, par rapport à la médiatrice (14) qui part du point d'intersection des trois plans (11a, 11b, 11c) entre les lignes d'intersection du plan (11a) correspondant avec les plans adjacents (11b, 11c), dans le plan (11a) correspondant avec les capteurs (9) .

8. Objectif d'exposition selon la revendication 6 ou 7, **caractérisé en ce que**, à chacun des plans (11a, 11b, 11c), qui correspond à la zone de la structure de mesure (5), correspond un plan (11a, 11b, 11c) au niveau de l'élément optique (2).

9. Objectif d'exposition selon la revendication 8, **caractérisé en ce que** les plans (11a, 11b, 11c) sont reliés au niveau de l'élément optique (2) comme un angle de cube (10) avec l'élément optique (2).

10. Objectif d'exposition selon la revendication 8, **caractérisé en ce que** les plans (11a, 11b, 11c) sont conçus au niveau de l'élément optique (2) comme des surfaces de référence sur l'élément optique (2) lui-même.

11. Objectif d'exposition selon la revendication 3 ou 4, **caractérisé en ce que** les dispositifs (8) pour la mesure de la position de l'élément optique (2) sont conçus comme des trajectoires de mesures interférométriques (16, 16').

12. Objectif d'exposition selon la revendication 11, **caractérisé en ce que** les trajectoires de mesure (16, 16') sont réalisées à l'aide d'un interféromètre laser (15), au moins six interféromètres laser (15), reliés de manière fixe avec la structure de mesure (5), correspondant à chacun des éléments optiques (2).

13. Objectif d'exposition selon la revendication 12, **caractérisé en ce que** les rayons laser des interféromètres laser (15) sont réfléchis par des rétro-réflecteurs (17) reliés à l'élément optique (2), chaque élément optique (2) comprenant au moins six rétro-réflecteurs (17) et chacun des rétro-réflecteurs (17) correspondant à un des interféromètres laser (15).

14. Objectif d'exposition selon l'une des revendications 3 à 13, **caractérisé en ce que**, pour chaque élément optique (2), au moins sept dispositifs (8) sont prévus pour la mesure de sa position.

15. Objectif d'exposition selon l'une des revendications 3 à 14, **caractérisé en ce que** les valeurs déterminées à partir des dispositifs (8) de mesure de la position de l'élément optique (2) peuvent être transformées, dans une unité de traitement de données, en valeurs absolues de position de l'élément optique (2) correspondant.

16. Objectif d'exposition selon l'une des revendications 1 à 15, **caractérisé en ce que** la structure porteuse (3) et la structure de mesure (5) sont disposées sur une plaque de base commune (4).

17. Objectif d'exposition selon l'une des revendications 1 à 16, **caractérisé en ce que** la liaison entre la structure de mesure (5) et la structure porteuse (3) est constituée d'une combinaison d'au moins un élément élastique (6) et au moins un amortisseur (7).

18. Objectif d'exposition selon l'une des revendications 1 à 17, **caractérisé en ce que** la structure de mesure (3) est constituée d'un matériau qui présente, au moins du point de vue macroscopique, un coefficient de dilatation thermique qui est au moins approximativement égal à zéro.

19. Procédé de modification de la position d'un objet et/ou d'une image dans un objectif d'exposition selon l'une des revendications 1 à 18, **caractérisé en ce que** la position de l'objet et/ou de l'image est modifiée à l'aide d'une modification de la position d'au moins un élément optique (2), la position de l'élément optique (2) par rapport à la structure de mesure (5) étant mesurée en connaissant au moins la position de l'objet et la position cible de l'image par rapport à la structure de mesure (5).
